# EUROPÄISCHE PATENTSCHRIFT

(11) **EP 3 472 844 B1**
(45) Veröffentlichungstag und Bekanntmachung des Hinweises auf die Patenterteilung: **19.05.2021**
(21) Anmeldenummer: 17736918.8
(22) Anmeldetag: 03.07.2017
(51) Int. Cl.: H01C 7/06, H01C 17/232, H01C 17/24, G01R 1/20, G01R 19/32, H01C 17/242

(54) **WIDERSTAND UND HERSTELLUNGSVERFAHREN DAFÜR**
RESISTOR AND METHOD OF MANUFACTURING IT
RÉSISTANCE ET SA MÉTHODE DE FABRICATION

(30) Priorität: 11.07.2016 DE 102016008415
(43) Veröffentlichungstag der Anmeldung: 24.04.2019
(73) Patentinhaber: Isabellenhütte Heusler GmbH & Co. Kg, 35683 Dillenburg (DE)
(72) Erfinder: HETZLER, Ullrich, 35688 Dillenburg-Oberscheld (DE)
(74) Vertreter: v. Bezold & Partner Patentanwälte - PartG mbB
(86) Internationale Anmeldenummer: PCT/EP2017/066507
(87) Internationale Veröffentlichungsnummer: WO 2018/010996

(56) Entgegenhaltungen:
- DE-A1-102013 005 939
- DE-U1-202010 005 756
- FR-A1- 2 568 684
- FR-A1- 2 884 615
- US-A- 1 407 147

## Beschreibung

Die Erfindung betrifft einen Widerstand, insbesondere einen niederohmigen Strommesswiderstand, sowie ein Herstellungsverfahren für einen solchen Widerstand.

Niederohmige Widerstände mit Widerstandswerten im Bereich von wenigen pOhm bis zu einigen 100µOhm werden zunehmend für die hochgenaue Messung hoher Gleich- und Wechselströme von 100 A bis zu 20 kA eingesetzt. Dabei sind die gemessenen Spannungen jedoch sehr niedrig im mV-Bereich gelegen, sodass bei den geforderten Auflösungen von 16 Bit bzw. 0,01% Spannungen im µV-Bereich gemessen werden müssen. Das bedeutet aber, dass Fehlerspannungen, z.B. durch thermoelektrische Effekte oder Induktion erzeugt, bereits erhebliche Fehler verursachen können. Insbesondere trifft das dann zu, wenn in Wechselströmen ein kleiner Gleichstromanteil erfasst werden muss. In diesem Fall muss das Mess-System absolut Offset-frei sein und gleichzeitig müssen die extrem störenden thermoelektrischen Spannungen vermieden werden. Diese entstehen beim Kontakt zweier verschiedener leitfähiger Materialien, wenn gleichzeitig ein Temperaturgradient in der Kontaktstelle vorhanden ist. In der Messtechnik versucht man diese Fehler zu vermeiden, indem man Temperaturgradienten möglichst vermeidet, nur gleichartige Materialien miteinander verbindet oder, falls nicht vermeidbar, verschiedenartige Materialien thermoelektrisch durch geeignete Legierungsoptimierung aufeinander abstimmt. Bei Widerständen bedeutet das, dass das verwendete Widerstandsmaterial dem Kupfer thermoelektrisch optimal angepasst werden sollte. Diese Forderung ist für die bekannten Präzisionswiderstandslegierungen Manganin®, Zeranin® und Isaohm® in hohem Masse erfüllt. Trotzdem sind bei den heutigen Messmöglichkeiten die durch die Rest-Thermospannungen gegebenen Fehler deutlich sichtbar und begrenzen letztendlich die Auflösung und Güte der Messung. Durch die Messung der Temperaturdifferenz über dem Widerstand und eine Kalibriermessung ist zwar eine grobe Eliminierung dieses Fehlers möglich. Da aber die Thermokraft bei den verwendeten Widerstandsmaterialien im Allgemeinen stark von der Temperatur abhängt, ist dieses Verfahren aufwendig und in der Genauigkeit limitiert.

Zum technischen Hintergrund der Erfindung ist auch hinzuweisen auf DE 10 2013 005 939 A1, FR 2 659 177 A1 und DE 10 2010 009 835 A1.

Aus FR 2 884 615 A1 ist ein Widerstand gemäß dem Oberbegriff von Anspruch 1 und ein Herstellungsverfahren gemäß dem Oberbegriff von Anspruch 11 bekannt. Dieser Stand der Technik ist jedoch noch nicht vollständig befriedigend.

Der Erfindung liegt deshalb die Aufgabe zugrunde, bei einem Widerstand (z.B. niederohmiger Strommesswiderstand) die Messfehler zu minimieren, die durch Thermospannungen erzeugt werden.

Diese Aufgabe wird durch einen erfindungsgemäßen Widerstand bzw. ein erfindungsgemäßes Herstellungsverfahren gemäß den Nebenansprüchen gelöst.

Die Erfindung umfasst die allgemeine technische Lehre, die durch das Widerstandselement erzeugte störende Thermospannung durch eine entgegen gerichtete Thermospannung zu kompensieren, die durch ein thermisch parallel geschaltetes Ausgleichselement erzeugt wird.

Der erfindungsgemäße Widerstand weist zunächst in Übereinstimmung mit dem Stand der Technik ein erstes Anschlussteil aus einem Leitermaterial (z.B. Kupfer, Kupferlegierung) auf, wobei das erste Anschlussteil vorzugsweise dazu dient, einen zu messenden elektrischen Strom in den Widerstand einzuleiten.

Darüber hinaus weist der erfindungsgemäße Widerstand in Übereinstimmung mit dem Stand der Technik ein zweites Anschlussteil aus dem Leitermaterial (z.B. Kupfer, Kupferlegierung) auf, wobei das zweite Anschlussteil vorzugsweise dazu dient, den zu messenden elektrischen Strom aus dem Widerstand auszuleiten.

Weiterhin umfasst der erfindungsgemäße Widerstand ein Widerstandselement aus einem Widerstandsmaterial (z.B. Manganin®), wobei das Widerstandselement in Stromrichtung zwischen dem ersten Anschlussteil und dem zweiten Anschlussteil angeordnet ist und von dem zu messenden elektrischen Strom durchströmt wird.

Das Widerstandsmaterial des Widerstandselements weist hierbei eine bestimmte Thermokraft auf, die bei einem Temperaturunterschied zwischen dem Widerstandselement einerseits und den angrenzenden Anschlussteilen andererseits eine bestimmte Thermospannung erzeugt, die ohne eine Kompensation zu einem Messfehler führt, wie bereits eingangs zum Stand der Technik erläutert wurde.

Der erfindungsgemäße Widerstand weist deshalb zusätzlich ein Ausgleichselement auf, das im Betrieb eine Thermospannung erzeugt, welche die von dem Widerstandselement erzeugte Thermospannung mindestens teilweise kompensiert.

Gemäß der Erfindung weist der Widerstand zwei Spannungsabgriffe auf, die elektrisch leitend mit dem ersten bzw. zweiten Anschlussteil verbunden sind und gemäß der bekannten Vierleitertechnik eine Messung der über dem Widerstandselement abfallenden elektrischen Spannung ermöglichen. Hierzu kann an die beiden Spannungsabgriffe ein Spannungsmesskreis mit einem Spannungsmessgerät angeschlossen werden.

Im einfachsten Fall bestehen die beiden Spannungsabgriffe aus einem Flächenabschnitt an der Oberfläche der beiden Anschlussteile, um eine Spannungsmessleitung kontaktieren zu können. Es ist jedoch alternativ auch möglich, dass die beiden Spannungsabgriffe aus seitlichen Vorsprüngen bestehen, die an die Anschlussteile angeformt sind. Die Erfindung ist also hinsichtlich der konstruktiven Gestaltung der Spannungsabgriffe nicht bestimmte konkrete Ausführungsformen beschränkt.

Darüber hinaus ist zu erwähnen, dass der Widerstand vorzugsweise auch zwei Stromanschlüsse aufweist, um den Strom in den Widerstand einzuleiten bzw. aus dem Widerstand auszuleiten. Diese Stromanschlüsse befinden sich dann an den beiden Anschlussteilen. Beispielsweise können hier Kabel oder Stromschienen angelötet oder angeschweißt oder über eine Schraubverbindung montiert werden. Diese Stromanschlüsse können z.B. aus einer Bohrung in den Anschlussteilen bestehen. In diese Bohrung kann dann jeweils eine Stromkontaktschraube eingeschraubt werden. Alternativ besteht die Möglichkeit, dass die Stromanschlüsse jeweils eine Schraube aufweisen, die an die Anschlussteile angeformt ist. Derartige Stromanschlüsse sind an sich aus dem Stand der Technik bekannt (z.B. EP 0 605 800 A1) und müssen deshalb nicht näher beschrieben werden.

In dem bevorzugten Ausführungsbeispiel der Erfindung ist das Ausgleichselement thermisch parallel geschaltet zu dem Widerstandselement, so dass das Ausgleichselement im Wesentlichen denselben Temperaturunterschieden ausgesetzt ist wie das Widerstandselement und deshalb betragsmäßig im Wesentlichen dieselbe Thermospannung erzeugt wie das Widerstandselement.

Das Ausgleichselement ist hierbei in dem Spannungsmesskreis vorzugsweise in Reihe mit dem Widerstandselement geschaltet, so dass sich die Thermospannungen des Widerstandselements einerseits und des Ausgleichselements andererseits mindestens teilweise kompensieren.

Gemäß der Erfindung ist der zur Potentialmessung an dem zweiten Anschlussteil dienende zweite Spannungsabgriff nicht an dem zweiten Anschlussteil angeordnet, sondern an dem ersten Anschlussteil. Der zweite Spannungsabgriff ist dabei elektrisch gegenüber dem ersten Anschlussteil isoliert. Das Ausgleichselement ist dabei an dem zweiten Spannungsabgriff thermisch leitend mit dem ersten Anschlussteil verbunden. Der zweite Spannungsabgriff ist dann über das Ausgleichselement mit einer Kontaktstelle an dem zweiten Anschlussteil elektrisch leitend verbunden. Darüber hinaus ist das Ausgleichselement an der Kontaktstelle an dem zweiten Anschlussteil elektrisch und thermisch leitend mit dem zweiten Anschlussteil verbunden. Dadurch wird erreicht, dass das Ausgleichselement thermisch parallel zu dem Widerstandselement und in dem Spannungsmesskreis in Reihe mit dem Widerstandselement geschaltet ist. Dies hat zur Folge, dass sich die Thermospannungen des Widerstandselements einerseits und des Ausgleichselements andererseits mindestens teilweise kompensieren.

In einer Variante der Erfindung ist das Ausgleichselement ein Draht, der vorzugsweise auch aus dem Widerstandsmaterial (z.B. Manganin®) des Widerstandselements besteht. Allerdings ist diese Erfindungsvariante mit einem Draht als Ausgangselement noch nicht optimal, und zwar wegen Chargenschwankungen und des Einflusses der Schweißnaht, möglichen Veränderungen der Thermospannung bei Umform- und Glühprozessen sowie logistischer Probleme. Darüber hinaus müsste der Draht von Hand montiert werden, was für eine Serienfertigung möglicherweise einen zu hohen Aufwand und damit zu hohe Kosten verursachen würde. Unabhängig davon ist die Handmontage nicht unproblematisch, da der Draht recht dünn sein sollte und eine Benetzung des Widerstandsmaterials (z.B. Manganin®) mit dem Lot bei der Verlötung die Thermospannung verändern könnte.

In einer anderen Erfindungsvariante ist deshalb vorgesehen, dass das Ausgleichselement ein Verbundmaterialplättchen derselben Charge ist, das außen aus dem Leitermaterial (z.B. Kupfer, Kupferlegierung) der Anschlussteile und mittig aus dem Widerstandsmaterial (z.B. Manganin®) des Widerstandselements besteht. Dadurch werden die vorstehend beschriebenen Probleme eines Ausgleichselements in Form eines Drahtes vermieden.

In einer weiteren Erfindungsvariante wird das Ausgleichselement aus dem fertigen Widerstand abgetrennt. Dies bedeutet, dass das Ausgleichselement einen Teil des Widerstandselements umfasst, der dann gegenüber dem Rest des Widerstandselements elektrisch isoliert ist. Dabei kann das Ausgleichselement auch einen Teil des ersten Anschlussteils umfassen, der dann gegenüber dem Rest des ersten Anschlussteils elektrisch isoliert ist.

Beispielsweise kann hierzu eine Trennfuge in den Widerstand eingebracht werden, wobei die Trennfuge das Ausgleichselement von dem Rest des Widerstandselements bzw. des ersten Anschlussteils abtrennt.

Diese Trennfuge kann beispielsweise durch einen Laserstrahl, einen Wasserstrahl oder durch Fräsen in den Widerstand eingebracht werden.

Vorzugsweise wird die Trennfuge in dem fertigen Widerstand durch ein Füllmaterial aufgefüllt, das elektrisch isolierend und thermisch leitfähig ist.

Bei einem aus dem Widerstandselement herausgearbeiteten Ausgleichselement weist das Ausgleichselement vorzugsweise eine reduzierte Dicke auf, die gegenüber dem Rest des Widerstands verringert ist. Die Dicke des Ausgleichselements kann dann beispielsweise kleiner als 50%, 30%, 20%, 10% oder sogar 5% der Dicke des Rests des Widerstands sein. Diese Dickenreduzierung kann beispielsweise erreicht werden, indem der Widerstand im Bereich des Ausgleichselements abgefräst wird.

Weiterhin ist zu erwähnen, dass es im Rahmen der Erfindung zu einer Überkompensation der Thermospannungen kommen kann. Zur Vermeidung einer solchen Überkompensation ist in einer Erfindungsvariante ein Spannungsteiler mit zwei Widerständen vorgesehen. Der Spannungsteiler ist dann parallel zu dem Kompensationselement geschaltet und weist einen Mittelabgriff auf, der einen externen Spannungsabgriff für ein Spannungsmessgerät bildet.

In einem Ausführungsbeispiel der Erfindung ist eine spezielle Leiterplatte vorgesehen, die einseitig anstelle einer Kupferfolie beispielsweise eine Manganin®-Folie als Ausgleichselement trägt. In diesem Fall kann die Struktur des Ausgleichselements wie in der Leiterplattentechnik üblich ätztechnisch mit großer Reproduzierbarkeit hergestellt werden. Die Leiterplatte trägt also in diesem Ausführungsbeispiel auch das Ausgleichselement. Weiterhin ist zu erwähnen, dass die Leiterplatte vorzugsweise mehrlagig ist und vorzugsweise mit dem Widerstand verlötet ist.

Das Ausgleichselement ist dabei vorzugsweise auf der dem Widerstand abgewandten Oberseite oder einer Innenlage der Leiterplatte angeordnet. Die Leiterplatte weist dann vorzugsweise eine erste elektrische Durchkontaktierung auf, die sowohl eine elektrische als auch eine thermisch (erste thermische Ankopplung) leitende Verbindung mit dem ersten Anschlussteil des Widerstands herstellt und elektrisch leitend mit dem ersten Spannungsabgriff verbunden ist. Darüber hinaus weist die Leiterplatte eine zweite thermische Ankopplung auf, die das Ausgleichselement thermisch mit dem zweiten Anschlussteil verbindet. Die beiden thermischen Ankopplungen stellen sicher, dass das Ausgleichselement thermisch parallel geschaltet ist zu dem Widerstandselement und deshalb denselben Temperaturunterschieden ausgesetzt ist.

Auch bei dieser Erfindungsvariante mit einer Leiterplatte kann ein Spannungsteiler vorgesehen sein, um die bereits eingangs erwähnte störende Überkompensation zu vermeiden, wobei dieser Spannungsteiler auf der Leiterplatte angeordnet sein kann.

Vorzugsweise besteht das Ausgleichselement aus einem Material, das im Wesentlichen die gleiche Thermokraft aufweist wie das Widerstandsmaterial, insbesondere mit einer Abweichung von weniger als ±10%, ±5%, ±2% oder sogar weniger als +1%.

Es ist deshalb vorteilhaft, wenn das Ausgleichselement auch aus dem Widerstandsmaterial des Widerstandselements besteht. Zur Vermeidung von herstellungsbedingten Schwankungen der Thermokraft des Widerstandsmaterials ist es auch vorteilhaft, wenn das Ausgleichselement und das Widerstandselement aus derselben Charge des Widerstandsmaterials hergestellt werden.

Ferner ist zu erwähnen, dass die Anschlussteile und/oder das Widerstandselement vorzugsweise plattenförmig sind, wie es beispielsweise aus EP 0 605 800 A1 bekannt ist. In diesem Zusammenhang ist zu erwähnen, dass die Anschlussteile und das Widerstandselement wahlweise eben oder gebogen sein können.

Es wurde bereits vorstehend erwähnt, dass es sich bei dem Leitermaterial der Anschlussteile vorzugsweise um Kupfer oder einer Kupferlegierung handelt. Es ist jedoch alternativ beispielsweise auch möglich, dass es sich bei dem Leitermaterial um Aluminium handelt. In diesem Zusammenhang ist auch zu erwähnen, dass es nicht zwingend erforderlich ist, dass die beiden Anschlussteile aus demselben Leitermaterial bestehen. Entscheidend ist lediglich, dass das Leitermaterial einen extrem niedrigen spezifischen elektrischen Widerstand aufweist.

Weiterhin wurde bereits vorstehend kurz erwähnt, dass es sich bei dem Widerstandsmaterial des Widerstandselements um Manganin® handeln kann. Dabei handelt es sich um die Kupfer-Mangan-Nickel-Legierung Cu86Mn12Ni2. Es besteht jedoch alternativ auch die Möglichkeit, dass es sich bei dem Widerstandsmaterial des Widerstandselements um eine andere Kupfer-Mangan-Nickel-Legierung oder eine Nickel-Chrom-Legierung handelt, um nur einige Beispiele zu nennen.

Entscheidend ist lediglich, dass das Widerstandsmaterial des Widerstandselements vorzugsweise einen größeren spezifischen elektrischen Widerstand aufweist als das Leitermaterial der Anschlussteile, was für eine Vierleitermessung wichtig ist.

Der spezifische elektrische Widerstand des Widerstandsmaterials kann also beispielsweise im Bereich von 1·10⁻⁸ Ωm bis 50 .10⁻⁷ Ωm liegen.

Der Widerstandswert des gesamten Widerstands liegt dagegen vorzugsweise im Bereich von 0,1 µΩ bis 3000 µΩ.

Ferner ist zu erwähnen, dass der erfindungsgemäße Widerstand vorzugsweise einen Widerstandswert mit einem sehr geringen Temperaturkoeffizienten hat, der vorzugsweise kleiner ist als 500 ppm/K.

Darüber hinaus ist noch zu erwähnen, dass die beiden Anschlussteile und das Widerstandselement aus einem Verbundmaterialband quer zur Längsrichtung des Verbundmaterialbands abgetrennt und optional gebogen sein können. Dies ist beispielsweise aus EP 0 605 800 A1 hinlänglich bekannt und muss deshalb nicht detailliert beschrieben werden.

Schließlich umfasst die Erfindung auch ein entsprechendes Herstellungsverfahren, wobei sich die Verfahrensschritte bereits aus der vorstehenden Beschreibung des erfindungsgemäßen Widerstands ergeben und deshalb nicht separat beschrieben werden müssen.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1: eine schematische Darstellung eines herkömmlichen niederohmigen Strommesswiderstands zur Strommessung gemäß der Vierleitertechnik,
- Figur 2: eine erfindungsgemäße Abwandlung eines niederohmigen Strommesswiderstands mit einem Ausgleichselement in Form eines Drahtes oder Bändchens,
- Figur 3: eine Abwandlung von Figur 2, wobei anstelle des Drahtes oder Bändchens ein Verbundmaterialplättchen als Ausgleichselement verwendet wird,
- Figur 4: eine Abwandlung von Figur 2, wobei das Ausgleichselement aus dem fertigen Widerstand herausgearbeitet ist,
- Figur 5: ein schematisches Schaltbild zur Verdeutlichung des Prinzips des Ausgleichselements,
- Figur 6: eine Abwandlung von Figur 5 mit einem zusätzlichen Spannungsteiler zur Vermeidung einer Überkompensation der Thermospannungen,
- Figur 7A: eine Querschnittsansicht durch einen erfindungsgemäßen Widerstand mit einer Leiterplatte, welche das Ausgleichselement trägt und zwar entlang der Schnittlinie A-A in Figur 7B,
- Figur 7B: eine Aufsicht auf das Ausführungsbeispiel gemäß Figur 7A, sowie
- Figur 8: eine Abwandlung von Figur 7B.

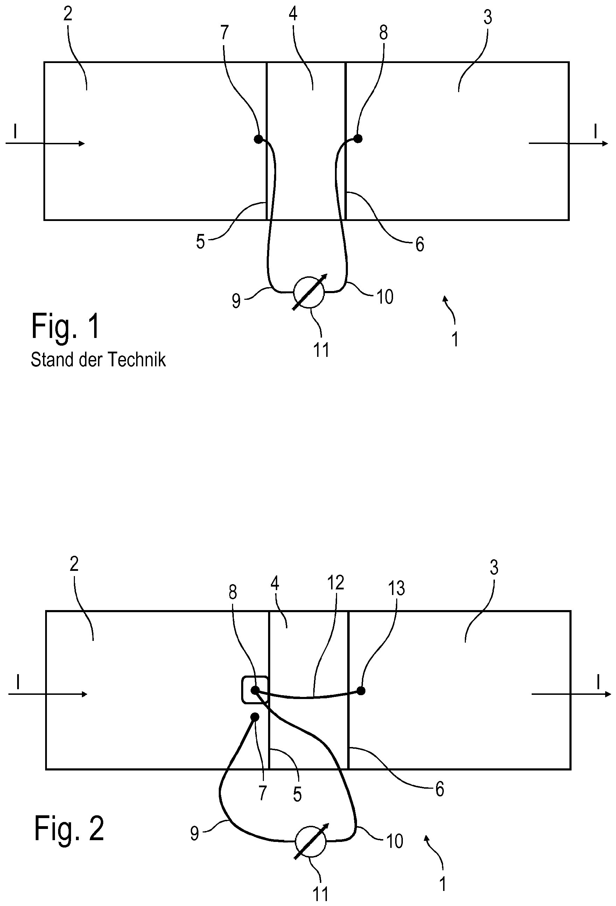

Figur 1 zeigt eine schematische Darstellung eines herkömmlichen niederohmigen Strommesswiderstands 1, wie er beispielsweise aus EP 0 605 800 A1 bekannt ist.

So weist der Strommesswiderstand 1 zunächst ein erstes plattenförmiges Anschlussteil 2 aus einem Leitermaterial (z.B. Kupfer, Kupferlegierung) auf, um einen zu messenden elektrischen Strom I in den Strommesswiderstand 1 einzuleiten.

Darüber hinaus weist der Strommesswiderstand 1 ein plattenförmiges zweites Anschlussteil 3 auf, das ebenfalls aus einem Leitermaterial (z.B. Kupfer, Kupferlegierung) besteht und dazu dient, den zu messenden elektrischen Strom I aus dem Strommesswiderstand 1 auszuleiten.

Zwischen den beiden Anschlussteilen 2, 3 ist ein ebenfalls plattenförmiges Widerstandselement 4 eingesetzt, das durch Schweißnähte 5, 6 elektrisch und mechanisch mit den beiden angrenzenden Anschlussteilen 2, 3 verbunden ist. Der zu messende elektrische Strom I wird also über das Anschlussteil 2 in den Strommesswiderstand 1 eingeleitet, fließt dann durch das Widerstandselement 4 und wird dann schließlich wieder über das Anschlussteil 3 aus dem Strommesswiderstand 1 ausgeleitet.

Über dem Widerstandselement 4 fällt also im Betrieb eine Spannung ab, die entsprechend dem ohmschen Gesetz proportional zu dem zu messenden elektrischen Strom I ist, was entsprechend der bekannten Vierleitertechnik eine Strommessung erlaubt.

An den beiden Anschlussteilen 2, 3 befinden sich deshalb in unmittelbarer Nähe zu dem Widerstandselement 4 zwei Spannungsabgriffe 7, 8, die über jeweils eine Spannungsmessleitung 9, 10 mit einem Spannungsmessgerät 11 verbunden sind. Die von dem Spannungsmessgerät 11 gemessene elektrische Spannung ist dann entsprechend dem ohmschen Gesetz ein direktes Maß für den durch den Strommesswiderstand einfließenden elektrischen Strom I.

Problematisch ist hierbei - wie bereits eingangs erwähnt - die Tatsache, dass das Leitermaterial der Anschlussteile 2, 3 in der Regel eine geringfügig andere Thermokraft aufweist als das Widerstandsmaterial des Widerstandselements 4. Dies hat zur Folge, dass es bei Temperaturunterschieden zwischen dem Widerstandselement 4 einerseits und den Anschlussteilen 2, 3 andererseits zu Thermospannungen kommt, welche die Spannungsmessung durch das Spannungsmessgerät 11 verfälschen.

Dieses Problem wird durch das erfindungsgemäße Ausführungsbeispiel gemäß Figur 2 gelöst, das nachfolgend beschrieben wird. Das Ausführungsbeispiel gemäß Figur 2 stimmt jedoch teilweise mit dem herkömmlichen Strommesswiderstand 1 gemäß Figur 1 überein, so dass zur Vermeidung von Wiederholungen auf die vorstehende Beschreibung Bezug genommen wird, wobei für entsprechende Einzelheiten dieselben Bezugszeichen verwendet werden.

Eine Besonderheit dieses Ausführungsbeispiels besteht darin, dass der zweite Spannungsabgriff 8 für die Potentialmessung an dem zweiten Anschlussteil 3 hierbei nicht an dem zweiten Anschlussteil 3 angeordnet ist, sondern an dem ersten Anschlussteil 2 und zwar nahe der Schweißnaht 5. Allerdings ist der zweite Spannungsabgriff 8 hierbei elektrisch gegenüber dem ersten Anschlussteil 2 isoliert und zwar beispielsweise durch eine elektrisch isolierte, thermisch gekoppelte Lötstelle.

Die elektrische Verbindung zwischen dem zweiten Spannungsabgriff 8 und dem zweiten Anschlussteil 3 erfolgt hierbei durch ein Ausgleichselement 12 in Form eines Drahtes oder Bändchens. Das Ausgleichselement 12 ist an seinem einen Ende elektrisch mit dem zweiten Spannungsabgriff 8 verbunden. An seinem gegenüber liegenden Ende ist das draht- oder bändchenförmige Ausgleichselement 12 dagegen elektrisch und thermisch mit einer Kontaktstelle 13 auf dem zweiten Anschlussteil 3 verbunden.

Diese Anordnung hat zur Folge, dass das fadenförmige Ausgleichselement 12 thermisch parallel geschaltet ist zu dem Widerstandselement 4 und deshalb im Betrieb denselben Temperaturunterschieden ausgesetzt ist wie das Widerstandselement 4. Dadurch erzeugt das fadenförmige Ausgleichselement 12 betragsmäßig auch dieselbe Thermospannung wie das Widerstandselement 4, da das Widerstandselement 4 aus demselben Widerstandsmaterial besteht wie das fadenförmige Ausgleichselement 12. Die thermische Kontaktierung wird hierbei zum einen durch den zweiten Spannungsabgriff 8 und zum anderen durch die Kontaktstelle 13 bewirkt.

Zum anderen hat diese Konstruktion zur Folge, dass das Ausgleichselement 12 in dem Spannungsmesskreis in Reihe geschaltet ist mit dem Widerstandselement 4, so dass sich die Thermospannungen des Widerstandselements einerseits und des Ausgleichselements 12 andererseits kompensieren.

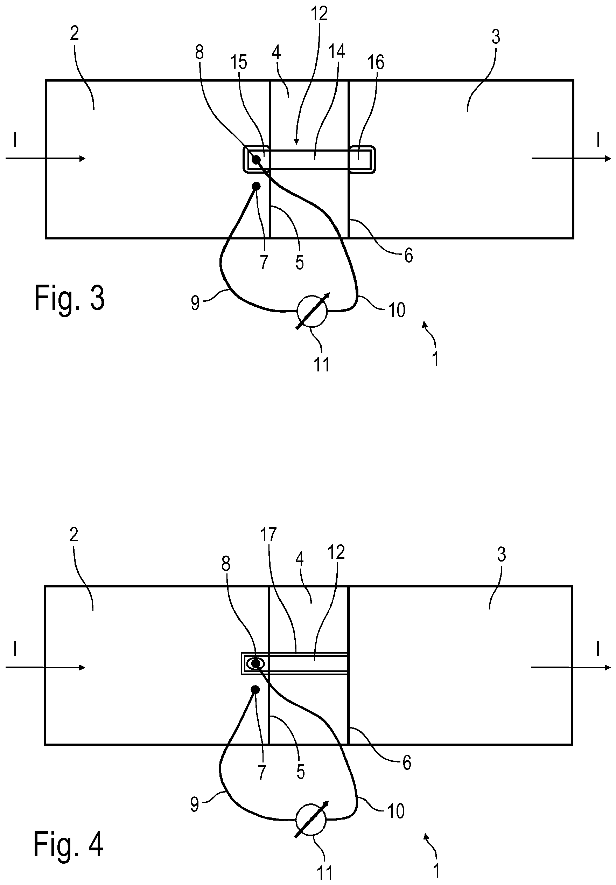

Figur 3 zeigt eine Abwandlung des Ausführungsbeispiels gemäß Figur 2, so dass zur Vermeidung von Wiederholungen auf die vorstehende Beschreibung Bezug genommen wird, wobei für entsprechende Einzelheiten dieselben Bezugszeichen verwendet werden.

Eine Besonderheit dieses Ausführungsbeispiels besteht darin, dass das Ausgleichselement 12 hierbei nicht durch einen Draht oder ein Bändchen gebildet wird, sondern durch ein Verbundmaterialplättchen mit einem Mittelteil 14 aus demselben Widerstandsmaterial wie das Widerstandselement 4 und zwei Außenteilen 15, 16 aus demselben Leitermaterial wie die beiden Anschlussteile 2, 3.

Ansonsten entspricht die Funktionsweise dieses Ausführungsbeispiels der Funktionsweise des Ausführungsbeispiels gemäß Figur 2, so dass zur Vermeidung von Wiederholungen auf die vorstehende Beschreibung verwiesen wird.

Figur 4 zeigt eine Abwandlung der Ausführungsbeispiele gemäß den Figuren 2 und 3, so dass zur Vermeidung von Wiederholungen wieder auf die vorstehende Beschreibung Bezug genommen wird, wobei für entsprechende Einzelheiten dieselben Bezugszeichen verwendet werden.

Eine Besonderheit dieses Ausführungsbeispiels besteht darin, dass das Ausgleichselement 12 nicht nachträglich mit dem Strommesswiderstand 1 verbunden wird. Stattdessen wird das Ausgleichselement 12 hierbei aus dem fertigen Strommesswiderstand 1 herausgearbeitet. Hierzu wird eine Trennfuge 17 in den Strommesswiderstand 1 eingebracht, beispielsweise mittels eines Laserstrahls, eines Wasserstrahls oder durch Fräsen. Die Trennfuge 17 trennt hierbei das Ausgleichselement 12 von dem Rest des Widerstandselements 4. Darüber hinaus trennt die Trennfuge 17 auch das Ausgleichselement 12 von dem Rest des Anschlussteils 2. Die Trennfuge 17 umrundet also auch den zweiten Spannungsabgriff 8 im Bereich des ersten Anschlussteils 2.

Die Funktionsweise dieses Ausführungsbeispiels entspricht der vorstehend beschriebenen Funktionsweise der anderen erfindungsgemäßen Ausführungsbeispiele, so dass diesbezüglich auf die vorstehende Beschreibung verwiesen werden kann, um Wiederholungen zu vermeiden.

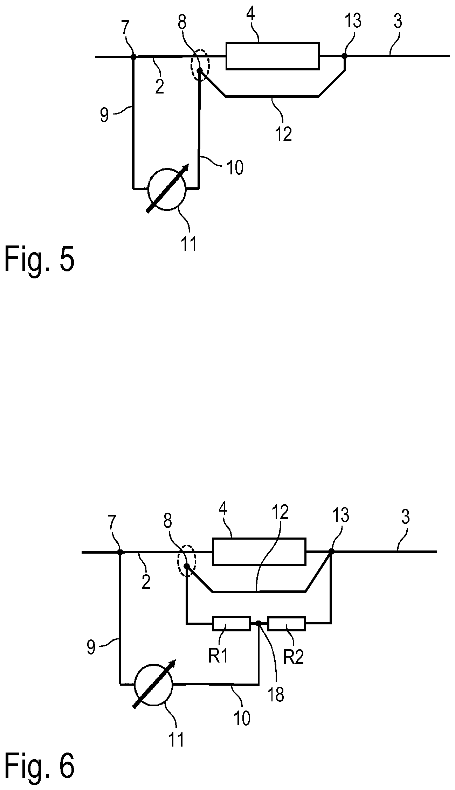

Figur 5 zeigt ein schematisches Ersatzschaltbild der Ausführungsbeispiele gemäß den Figuren 2-4.

Hierzu ist zu erwähnen, dass es unter Umständen zu einer Überkompensation der Thermospannung kommen kann. Zur Vermeidung einer solchen Überkompensation ist in dem Ausführungsbeispiel gemäß Figur 6 vorgesehen, dass ein Spannungsteiler bestehend aus zwei Widerständen R1, R2 parallel zu dem Ausgleichselement 12 geschaltet ist, wobei der Spannungsteiler aus den Widerständen R1, R2 einen Mittelabgriff 18 aufweist, der mit dem Spannungsmessgerät 11 verbunden ist.

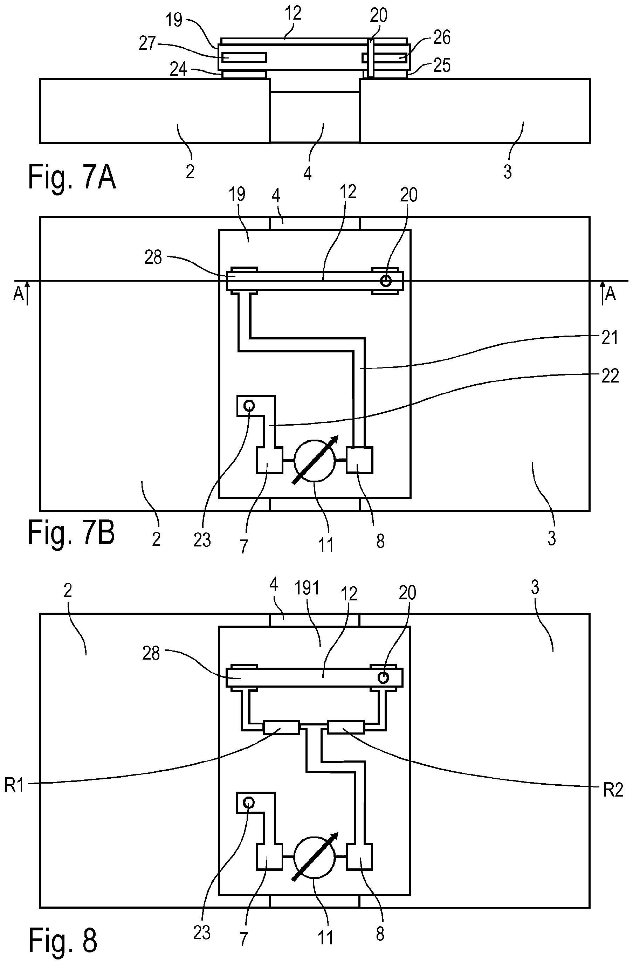

Die Figuren 7A und 7B zeigen ein weiteres Ausführungsbeispiel eines erfindungsgemäßen Strommesswiderstands 1. Auch dieses Ausführungsbeispiel stimmt teilweise mit den vorstehend beschriebenen Ausführungsbeispielen überein, so dass zur Vermeidung von Wiederholungen auf die vorstehende Beschreibung Bezug genommen wird, wobei für entsprechende Einzelheiten dieselben Bezugszeichen verwendet werden.

Eine Besonderheit dieses Ausführungsbeispiels besteht darin, dass das Ausgleichselement 12 als Folie realisiert ist, die auf einer Leiterplatte 19 angeordnet ist und zwar auf der Oberseite oder eine der Innenlagen der Leiterplatte 19. Die Leiterplatte 19 ist hierbei an der Oberseite des Strommesswiderstands 1 angeordnet und thermisch und elektrisch mit dem Strommesswiderstand 1 verbunden (bevorzugt verlötet, Lötstellen 24, 25), wie nachfolgend noch erläutert wird.

So weist die Leiterplatte 19 eine elektrische Durchkontaktierung 20 auf, die das Ausgleichselement 12 mit dem zweiten Anschlussteil 3 elektrisch und thermisch verbindet.

Auf dem gegenüber liegenden Ende ist das Ausgleichselement 12 mit einer Kupferbahn 21 verbunden, die das Ausgleichselement 12 elektrisch leitend mit dem zweiten Spannungsabgriff 8 verbindet.

Der erste Spannungsabgriff 7 ist dagegen über eine weitere Kupferbahn 22 mit einer elektrischen Durchkontaktierung 23 verbunden, die einen elektrischen Kontakt herstellt mit dem ersten Anschlussteil 2. Durch diese Konstruktion wird wieder erreicht, dass das Ausgleichselement 12 thermisch parallel geschaltet ist zu dem Widerstandselement 4, während das Ausgleichselement 12 in dem Spannungsmesskreis in Reihe geschaltet ist mit dem Widerstandselement 4, damit sich die Thermospannungen des Widerstandselements einerseits und des Ausgleichselements 12 andererseits kompensieren.

Hierbei ist zu erwähnen, dass auch thermische Kopplungen 26, 27, bestehend aus geeignet geformten Cu-Innenlagen, vorgesehen sind, welche die Enden des Ausgleichselements 12 thermisch besser mit dem Anschlussteil 2 bzw. dem Anschlussteil 3 verbinden.

Figur 8 zeigt eine Abwandlung von Figur 7B mit dem bereits in Figur 6 dargestellten Spannungsteiler aus den Widerständen R1 und R2. Hinsichtlich der Funktionsweise dieser Abwandlung kann deshalb auf die vorstehende Beschreibung zu Figur 6 verwiesen werden.

### Bezugszeichenliste:

1 Strommesswiderstand
2 Erstes Anschlussteil
3 Zweites Anschlussteil
4 Widerstandselement
5 Schweißnaht
6 Schweißnaht
7 Erster Spannungsabgriff
8 Zweiter Spannungsabgriff
9 Spannungsmessleitung
10 Spannungsmessleitung
11 Spannungsmessgerät
12 Ausgleichselement
13 Kontaktstelle des Ausgleichselements an dem zweiten Anschlussteil
14 Mittelteil des Ausgleichselements
15 Außenteil des Ausgleichselements
16 Außenteil des Ausgleichselements
17 Trennfuge
18 Mittelabgriff des Spannungsteilers
19 Leiterplatte
20 Elektrische Durchkontaktierung
21 Kupferbahn
22 Kupferbahn
23 Elektrische Durchkontaktierung
24 Lötstelle
25 Lötstelle
26 Cu-Innenlage zur besseren thermische Kopplung
27 Cu-Innenlage zur besseren thermische Kopplung
28 Kontaktstelle
I Strom
R1 Widerstand des Spannungsteilers
R2 Widerstand des Spannungsteilers

## Patentansprüche

1. Widerstand (1), insbesondere niederohmiger Strommesswiderstand (1), mit
a) einem ersten Anschlussteil (2) aus einem Leitermaterial, insbesondere zum Einleiten eines elektrischen Stroms (I) in den Widerstands (1),
b) einem zweiten Anschlussteil (3) aus dem Leitermaterial, insbesondere zum Ausleiten des elektrischen Stroms (I) aus dem Widerstand (1),
c) einem Widerstandselement (4) aus einem Widerstandsmaterial, wobei
c1) das Widerstandselement (4) in Stromrichtung zwischen dem ersten Anschlussteil (2) und dem zweiten Anschlussteil (3) angeordnet ist und von dem elektrischen Strom (I) durchströmt wird, und
c2) das Widerstandsmaterial eine bestimmte Thermokraft aufweist, die bei einem Temperaturunterschied zwischen dem Widerstandselement (4) einerseits und den Anschlussteilen (2, 3) andererseits eine bestimmte Thermospannung erzeugt,
d) einem Ausgleichselement (12), das im Betrieb eine Thermospannung erzeugt, welche die von dem Widerstandselement (4) erzeugte Thermospannung mindestens teilweise kompensiert,
e) einem ersten Spannungsabgriff (7), der elektrisch leitend mit dem ersten Anschlussteil (2) verbunden ist, und
f) einem zweiten Spannungsabgriff (8), der elektrisch leitend mit dem zweiten Anschlussteil (3) verbunden ist,
g) wobei an dem ersten Spannungsabgriff (7) und an dem zweiten Spannungsabgriff (8) ein Spannungsmesskreis (9, 10, 11) anschließbar ist, um die Spannung über dem Widerstandselement (4) zu messen,
**dadurch gekennzeichnet,**
h) dass der zweite Spannungsabgriff (8) an dem ersten Anschlussteil (2) angeordnet ist,
i) dass der zweite Spannungsabgriff (8) elektrisch gegenüber dem ersten Anschlussteil (2) isoliert ist,
j) dass das Ausgleichselement (12) an dem zweiten Spannungsabgriff (8) thermisch leitend mit dem ersten Anschlussteil (2) verbunden ist,
k) dass der zweite Spannungsabgriff (8) über das Ausgleichselement (12) mit einer Kontaktstelle (13) an dem zweiten Anschlussteil (3) elektrisch leitend verbunden ist, und
1) dass das Ausgleichselement (12) an der Kontaktstelle (13) an dem zweiten Anschlussteil (3) elektrisch und thermisch leitend mit dem zweiten Anschlussteil (3) verbunden ist.

2. Widerstand (1) nach Anspruch 1,
**dadurch gekennzeichnet,**
a) **dass** das Ausgleichselement (12) thermisch parallel geschaltet ist zu dem Widerstandselement (4), so dass das Ausgleichselement (12) im Wesentlichen denselben Temperaturunterschieden ausgesetzt ist wie das Widerstandselement (4) und deshalb betragsmäßig im Wesentlichen dieselbe Thermospannung erzeugt wie das Widerstandselement (4), und
b) **dass** das Ausgleichselement (12) in dem Spannungsmesskreis (9, 10, 11) in Reihe mit dem Widerstandselement (4) geschaltet ist, so dass sich die Thermospannungen des Widerstandselements (4) und des Ausgleichselements (12) mindestens teilweise kompensieren.

3. Widerstand (1) nach einem der vorhergehenden Ansprüche, **dadurch gekennzeichnet,**
a) **dass** das Ausgleichselement (12) ein Draht oder ein Bändchen ist, oder
b) **dass** das Ausgleichselement (12) ein Verbundmaterialplättchen ist, das außen aus dem Leitermaterial der Anschlussteile und mittig aus dem Widerstandsmaterial des Widerstandselements (4) besteht, oder
c) **dass** das Ausgleichselement (12) einen Teil des Widerstandselements (4) umfasst, der gegenüber dem Rest des Widerstandselements (4) elektrisch isoliert ist.

4. Widerstand (1) nach Anspruch 3, **dadurch gekennzeichnet, dass** das Ausgleichselement (12) auch einen Teil des ersten Anschlussteils (2) umfasst, der gegenüber dem Rest des ersten Anschlussteils (2) elektrisch isoliert ist.

5. Widerstand (1) nach Anspruch 3 oder 4,
**dadurch gekennzeichnet,**
a) **dass** das Ausgleichselement (12) durch eine Trennfuge (17) elektrisch von dem Rest des ersten Anschlussteils (2) und des Widerstandselements (4) getrennt ist, und
b) **dass** die Trennfuge (17) durch einen Laserstrahl oder einen Wasserstrahl oder durch Fräsen in den Widerstand (1) eingebracht ist, und
c) **dass** die Trennfuge (17) mindestens teilweise mit einem Füllmaterial ausgefüllt ist, und
d) **dass** das Füllmaterial thermisch leitfähig und elektrisch isolierend ist.

6. Widerstand (1) nach einem der vorhergehenden Ansprüche, **dadurch gekennzeichnet,**
a) **dass** das Ausgleichselement (12) gegenüber dem Rest des Widerstands (1) eine verringerte Dicke aufweist, und
b) **dass** die Dicke des Ausgleichselements (12) kleiner ist als 50% der Dicke des Rests des Widerstands (1), und
c) **dass** die Dickenreduzierung des Ausgleichselements (12) erzeugt ist durch Abfräsen des Widerstands (1) im Bereich des Ausgleichselements (12).

7. Widerstand (1) nach einem der vorhergehenden Ansprüche, **gekennzeichnet durch** einen Spannungsteiler (R1, R2) mit zwei Widerständen (R1, R2), wobei der Spannungsteiler (R1, R2) parallel zu dem Ausgleichselement (12) geschaltet ist und mit seinem Mittelabgriff (18) einen externen Spannungsabgriff bildet.

8. Widerstand (1) nach einem der vorhergehenden Ansprüche, **dadurch gekennzeichnet,**
a) **dass** auf dem Widerstand (1) eine Leiterplatte (19) angebracht ist, die das Ausgleichselement (12) trägt, und
b) **dass** das Ausgleichselement (12) eine Folie ist, die ätztechnisch hergestellt ist, und
c) **dass** die Leiterplatte (19) mehrlagig ist, und
d) **dass** die Leiterplatte (19) mit dem Widerstand (1) verlötet ist.

9. Widerstand (1) nach Anspruch 8,
**dadurch gekennzeichnet,**
a) **dass** das Ausgleichselement (12) auf der dem Widerstand (1) abgewandten Oberseite oder einer Innenlage der Leiterplatte (19) angeordnet ist,
b) **dass** die Leiterplatte (19) eine erste elektrische Durchkontaktierung (23) aufweist, die eine elektrisch leitende Verbindung mit dem ersten Anschlussteil (2) herstellt und elektrisch leitend mit dem ersten Spannungsabgriff (7) verbunden ist,
c) **dass** die Leiterplatte (19) eine zweite elektrische Durchkontaktierung (20) aufweist, die das Ausgleichselement (12) elektrisch und thermisch leitend mit dem zweiten Anschlussteil (3) verbindet,
d) **dass** die Leiterplatte (19) eine Leiterbahn (21), insbesondere aus Kupfer, aufweist, die eine elektrische Verbindung zwischen dem zweiten Spanungsabgriff (8) und dem Ausgleichselement (12) über eine geeignete Kontaktierung (28) herstellt,
e) **dass** die Leiterplatte (19) zwei Lötstellen (24, 25) aufweist, die die Leiterplatte (19) thermisch und elektrisch mit dem ersten Anschlussteil (2) bzw. dem zweiten Anschlussteil (3) verbindet,
f) **dass** die Leiterplatte (19) mindestens eine Innenlagenfläche (26, 27), insbesondere aus Kupfer, aufweist, die das Ausgleichselement (12) thermisch mit den Anschlussteilen (2, 3) verbindet, und
g) **dass** der Spannungsteiler (R1, R2) auf der Leiterplatte (19) angeordnet ist.

10. Widerstand (1) nach einem der vorhergehenden Ansprüche, **dadurch gekennzeichnet,**
a) **dass** das Ausgleichselement (12) aus einem Material besteht, das im Wesentlichen die gleiche Thermokraft aufweist wie das Widerstandsmaterial, insbesondere mit einer Abweichung von weniger als ±10%, und
b) **dass** das Ausgleichselement (12) auch aus dem Widerstandsmaterial des Widerstandselements (4) besteht, und
c) **dass** die Anschlussteile (2, 3) jeweils plattenförmig sind, und
d) **dass** das Widerstandselement (4) plattenförmig ist, und
e) **dass** das Leitermaterial der Anschlussteile (2, 3) Kupfer oder eine Kupferlegierung oder Aluminium ist, und
f) **dass** das Widerstandsmaterial eine Kupfer-Mangan-Legierung, insbesondere eine Kupfer-Mangan-NickelLegierung, oder eine Nickel-Chrom-Legierung ist, und
g) **dass** das Widerstandsmaterial des Widerstandselements (4) einen größeren spezifischen elektrischen Widerstand (1) aufweist als das Leitermaterial der Anschlussteile, und
h) **dass** das Widerstandsmaterial des Widerstandselements (4) einen spezifischen elektrischen Widerstand (1) aufweist, der kleiner als 50·10⁻⁷ Ωm und größer als 1·10⁻⁸ Ωm ist, und
i) **dass** der Widerstand (1) einen Widerstandswert aufweist, der mindestens 0,1 µΩ und höchstens 1000 µΩ beträgt.

11. Herstellungsverfahren für einen Widerstand (1), insbesondere für einen niederohmigen Strommesswiderstand (1) nach einem der vorhergehenden Ansprüche, mit den folgenden Schritten:
a) Bereitstellung des Widerstands (1) mit einem ersten Anschlussteil (2) aus einem Leitermaterial, einem zweiten Anschlussteil (3) aus dem Leitermaterial und einem Widerstandselement (4) aus einem Widerstandsmaterial,
a1) wobei das Widerstandselement (4) in Stromrichtung zwischen dem ersten Anschlussteil (2) und dem zweiten Anschlussteil (3) angeordnet ist und von dem elektrischen Strom (I) durchströmt wird,
a2) wobei das Widerstandsmaterial eine bestimmte Thermokraft aufweist, die bei einem Temperaturunterschied zwischen dem Widerstandselement (4) einerseits und den Anschlussteilen (2, 3) andererseits eine bestimmte Thermospannung erzeugt,
a3) wobei ein erster Spannungsabgriff (7) elektrisch leitend mit dem ersten Anschlussteil (2) verbunden wird,
a4) wobei ein zweiter Spannungsabgriff (8) elektrisch leitend mit dem zweiten Anschlussteil (3) verbunden wird,
a5) wobei an dem ersten Spannungsabgriff (7) und an dem zweiten Spannungsabgriff (8) ein Spannungsmesskreis (9, 10, 11) angeschlossen wird, um die Spannung über dem Widerstandselement (4) zu messen,
b) Bereitstellen eines Ausgleichselements (12) an dem Widerstand (1), wobei das Ausgleichselement (12) im Betrieb eine Thermospannung erzeugt, welche die von dem Widerstandselement (4) erzeugte Thermospannung mindestens teilweise kompensiert,
**dadurch gekennzeichnet,**
c) dass der zweite Spannungsabgriff (8) an dem ersten Anschlussteil (2) angeordnet wird,
d) dass der zweite Spannungsabgriff (8) elektrisch gegenüber dem ersten Anschlussteil (2) isoliert wird,
e) dass das Ausgleichselement (12) an dem zweiten Spannungsabgriff (8) thermisch leitend mit dem ersten Anschlussteil (2) verbunden wird,
f) dass der zweite Spannungsabgriff (8) über das Ausgleichselement (12) mit einer Kontaktstelle (13) an dem zweiten Anschlussteil (3) elektrisch leitend verbunden wird, und
g) dass das Ausgleichselement (12) an der Kontaktstelle (13) an dem zweiten Anschlussteil (3) elektrisch und thermisch leitend mit dem zweiten Anschlussteil (3) verbunden wird.

12. Herstellungsverfahren nach Anspruch 11,
**gekennzeichnet durch** folgende Schritte:
a) Einbringen einer Trennfuge (17) in den Widerstand (1) zur Abtrennung des Ausgleichselements (12) gegenüber dem Rest des Widerstandselements (4), insbesondere mittels
a1) eines Laserstrahls,
a2) eines Wasserstrahls, oder
a3) eines Fräsers, und/oder
b) Auffüllen der Trennfuge (17) mit einem Füllmaterial, das elektrisch isolierend und thermisch leitfähig ist, und/oder
c) Reduzieren der Dicke des Ausgleichselements (12) gegenüber dem Rest des Widerstands (1), insbesondere **durch** Abfräsen des Ausgleichselements (12).

## Claims

1. Resistor (1), in particular low-resistance current measuring resistor (1), with
a) a first connecting part (2) made of a conductor material, in particular for introducing an electric current (I) into the resistor (1),
b) a second connecting part (3) made of the conductor material, in particular for conducting the electric current (I) out of the resistor (1),
c) a resistor element (4) made of a resistance material, where
c1) the resistor element (4) is arranged in the current direction between the first connecting part (2) and the second connecting part (3) and through which the electric current (I) flows, and
c2) the resistance material has a specific thermal force which generates a specific thermoelectric voltage at a temperature difference between the resistor element (4) on the one hand and the connecting parts (2, 3) on the other hand,
d) a compensating element (12) which in operation generates a thermoelectric voltage which at least partially compensates the thermoelectric voltage generated by the resistor element (4),
e) a first voltage tap (7) which is electrically conductively connected to the first connecting part (2),
f) a second voltage tap (8) which is electrically conductively connected to the second connecting part (3),
g) wherein a voltage measuring circuit (9, 10, 11) can be connected to the first voltage tap (7) and to the second voltage tap (8) in order to measure the voltage across the resistor element (4),
**characterized in**
h) that the second voltage tap (8) is arranged on the first connecting part (2),
i) that the second voltage tap (8) is electrically insulated from the first connecting part (2),
j) that the compensating element (12) is thermally conductively connected to the first connecting part (2) at the second voltage tap (8),
k) that the second voltage tap (8) is electrically conductively connected via the compensating element (12) to a contact point (13) on the second connecting part (3), and
1) that the compensating element (12) is electrically and thermally conductively connected to the second connecting part (3) at the contact point (13) on the second connecting part (3).

2. Resistor (1) according to claim 1,
**characterized in**
a) **that** the compensating element (12) is thermally connected in parallel with the resistor element (4) so that the compensating element (12) is exposed to substantially the same temperature differences as the resistor element (4) and therefore generates substantially the same amount of thermoelectric voltage as the resistor element (4); and
b) **that** the compensating element (12) is connected in series with the resistor element (4) in the voltage measuring circuit (9, 10, 11) so that the thermoelectric voltages of the resistor element (4) and of the compensating element (12) at least partially compensate each other.

3. Resistor (1) according to one of the preceding claims, **characterized in**
a) **that** the compensating element (12) is a wire or a, or
b) **that** the compensating element (12) is a composite material plate which consists externally of the conductor material of the connecting parts and centrally of the resistance material of the resistor element (4), or
c) **that** the compensating element (12) comprises a part of the resistor element (4) which is electrically insulated from the rest of the resistor element (4).

4. Resistor (1) according to claim 3, **characterized in that** the compensating element (12) also comprises a part of the first connecting part (2) which is electrically insulated from the rest of the first connecting part (2).

5. Resistor (1) according to claim 3 or 4,
**characterized in**
a) **that** the compensating element (12) is electrically separated from the remainder of the first connecting part (2) and of the resistor element (4) by a separating slit (17), and
b) **that** the separating slit (17) is introduced into the resistor (1) by a laser beam or a water jet or by milling, and
c) **that** the separating slit (17) is at least partially filled with a filling material, and
d) **that** the filling material is thermally conductive and electrically insulating.

6. Resistor (1) according to one of the preceding claims, **characterized in**
a) **that** the compensating element (12) has a reduced thickness with respect to the remainder of the resistor (1), and
b) **that** the thickness of the compensating element (12) is less than 50% of the thickness of the remainder of the resistor (1), and
c) **that** the thickness reduction of the compensating element (12) is produced by milling off the resistor (1) in the region of the compensating element (12).

7. Resistor (1) according to one of the preceding claims, **characterized by** a voltage divider (R1, R2) having two resistors (R1, R2), the voltage divider (R1, R2) being connected in parallel with the compensating element (12) and forming an external voltage tap with its central tap (18).

8. Resistor (1) according to one of the preceding claims, **characterised in**
a) **that** a printed circuit board (19), which carries the compensating element (12), is mounted on the resistor (1); and
b) **that** the compensating element (12) is a foil which is produced by etching, and
c) **that** the printed circuit board (19) is multi-layered, and
d) **that** the printed circuit board (19) is soldered to the resistor (1).

9. Resistor (1) according to claim 8,
**characterized in**
a) **that** the compensating element (12) is arranged on the upper side facing away from the resistor (1) or on an inner layer of the printed circuit board (19),
b) **that** the printed circuit board (19) has a first electrical through-connection (23) which establishes an electrically conductive connection to the first connecting part (2) and is electrically conductively connected to the first voltage tap (7),
c) **that** the printed circuit board (19) has a second electrical through-connection (20) which electrically and thermally conductively connects the compensating element (12) to the second connecting part (3),
d) **that** the printed circuit board (19) has a conductor track (21), in particular made of copper, which establishes an electrical connection between the second voltage tap (8) and the compensating element (12) via a suitable contacting means (28),
e) **that** the printed circuit board (19) has two solder joints (24, 25) which connect the printed circuit board (19) thermally and electrically to the first connecting part (2) or the second connecting part (3) and
f) **that** the printed circuit board (19) has at least one inner layer surface (26, 27), in particular made of copper, which thermally connects the compensating element (12) to the connecting parts (2, 3), and
g) **that** the voltage divider (R1, R2) is arranged on the printed circuit board (19).

10. Resistor (1) to one of the preceding claims, **characterized in**
a) **that** the compensating element (12) is made of a material which has substantially the same thermal force as the resistance material, in particular with a deviation of less than ±10%, and
b) **that** the compensating element (12) also consists of the resistance material of the resistor element (4), and
c) **that** the connecting parts (2, 3) are each plate-shaped, and
d) **that** the resistor element (4) is plate-shaped, and
e) **that** the conductor material of the connecting parts (2, 3) is copper or a copper alloy or aluminium, and
f) **that** the resistance material is a copper-manganese alloy, in particular a copper-manganese nickel alloy, or a nickel-chromium alloy, and
g) **that** the resistance material of the resistor element (4) has a higher specific electrical resistance (1) than the conductor material of the connecting parts, and
h) **that** the resistance material of the resistor element (4) has a resistive electrical resistance (1) which is less than 50·10⁻⁷ Ωm, and greater than 1·10⁻⁸ Ωm, and
i) **that** the resistor (1) has a resistance value which is at least 0.1 µΩ and a maximum of 1000 µΩ.

11. Manufacturing method for a resistor (1), in particular for a low-resistance current measuring resistor (1) according to one of the preceding claims, having the following steps:
a) providing said resistor (1) comprising a first connecting part (2) made of a conductor material, a second connecting part (3) made of said conductor material, and a resistor element (4) made of a resistance material,
a1) the resistor element (4) being arranged in the current direction between the first connecting part (2) and the second connecting part (3) and through which the electric current (I) flows,
a2) the resistance material having a specific thermal force which, in the event of a temperature difference between the resistor element (4) on the one hand and the connecting parts (2, 3) on the other hand, generates a specific thermoelectric voltage,
a3) wherein a first voltage tap (7) which is electrically conductively connected to the first connecting part (2),
a4) wherein a second voltage tap (8) which is electrically conductively connected to the second connecting part (3),
a5) wherein a voltage measuring circuit (9, 10, 11) can be connected to the first voltage tap (7) and to the second voltage tap (8) in order to measure the voltage across the resistor element (4),
b) providing a compensating element (12) at the resistor (1), wherein the compensating element (12) in use generates a thermoelectric voltage which at least partially compensates for the thermoelectric voltage generated by the resistor element (4),
**characterized in**
c) that the second voltage tap (8) is arranged on the first connecting part (2),
d) that the second voltage tap (8) is electrically insulated from the first connecting part (2),
e) that the compensating element (12) is thermally conductively connected to the first connecting part (2) at the second voltage tap (8),
f) that the second voltage tap (8) is electrically conductively connected via the compensating element (12) to a contact point (13) on the second connecting part (3), and
g) that the compensating element (12) is electrically and thermally conductively connected to the second connecting part (3) at the contact point (13) on the second connecting part (3).

12. Manufacturing method according to claim 11, **characterized by** the following steps:
a) introducing a separating slit (17) into the resistor (1) for separating the compensating element (12) from the rest of the resistor element (4), in particular by means of
a1) a laser beam,
a2) a water jet, or
a3) a milling cutter, and/or
b) filling the separating slit (17) with a filling material which is electrically insulating and thermally conductive, and/or
c) reducing the thickness of the compensating element (12) with respect to the remainder of the resistor (1), in particular by milling off the compensating element (12) .

## Revendications

1. Résistance (1), en particulier résistance de mesure de courant à basse impédance (1), avec
a) une première partie de raccordement (2) composée d'un matériau conducteur, en particulier pour introduire un courant électrique (I) dans la résistance (1),
b) une deuxième partie de raccordement (3) composée du matériau conducteur, en particulier pour évacuer le courant électrique (I) hors de la résistance (1),
c) un élément de résistance (4) composé d'un matériau de résistance, dans laquelle
c1) l'élément de résistance (4) est disposé dans le sens du courant entre la première partie de raccordement (2) et la deuxième partie de raccordement (3) et est traversé par le courant électrique (I), et
c2) le matériau de résistance présente une certaine puissance thermoélectrique qui génère, dans le cas d'une différence de température entre l'élément de résistance (4) d'une part et les parties de raccordement (2, 3) d'autre part, une certaine tension thermoélectrique,
d) un élément de compensation (12) qui génère lors du fonctionnement une tension thermoélectrique, laquelle compense au moins en partie la tension thermoélectrique générée par l'élément de résistance (4),
e) une première prise de tension (7) qui est reliée de manière électriquement conductrice à la première partie de raccordement (2), et
f) une deuxième prise de tension (8) qui est reliée de manière électriquement conductrice à la deuxième partie de raccordement (3),
g) dans laquelle un circuit de mesure de tension (9, 10, 11) peut être raccordé à la première prise de tension (7) et à la deuxième prise de tension (8) pour mesurer la tension sur l'élément de résistance (4),
**caractérisée en ce**
h) que la deuxième prise de tension (8) est disposée sur la première partie de raccordement (2),
i) que la deuxième prise de tension (8) est isolée de manière électrique par rapport à la première partie de raccordement (2),
j) que l'élément de compensation (12) est relié de manière thermiquement conductrice à la première partie de raccordement (2) sur la deuxième prise de tension (8),
k) que la deuxième prise de tension (8) est reliée de manière électriquement conductrice à un point de contact (13) sur la deuxième partie de raccordement (3) par l'intermédiaire de l'élément de compensation (12), et
1) que l'élément de compensation (12) est relié de manière électrique et de manière thermiquement conductrice à la deuxième partie de raccordement (3) sur le point de contact (13) sur la deuxième partie de raccordement (3).

2. Résistance (1) selon la revendication 1,
**caractérisée en ce**
a) **que** l'élément de compensation (12) est branché thermiquement de manière parallèle par rapport à l'élément de résistance (4) de sorte que l'élément de compensation (12) est exposé sensiblement aux mêmes différences de température que l'élément de résistance (4) et génère pour cette raison en valeur absolue sensiblement la même tension thermoélectrique que l'élément de résistance (4), et
b) **que** l'élément de compensation (12) est branché dans le circuit de mesure de tension (9, 10, 11) en série avec l'élément de résistance (4) de sorte que les tensions thermoélectriques de l'élément de résistance (4) et de l'élément de compensation (12) se compensent au moins en partie.

3. Résistance (1) selon l'une quelconque des revendications précédentes,
**caractérisée en ce**
a) **que** l'élément de compensation (12) est un fil métallique ou une bandelette, ou
b) **que** l'élément de compensation (12) est une plaquette en matériau composite qui est constituée côté extérieur du matériau conducteur des parties de raccordement et au centre du matériau de résistance de l'élément de résistance (4), ou
c) **que** l'élément de compensation (12) comprend une partie de l'élément de résistance (4) qui est isolée de manière électrique par rapport au reste de l'élément de résistance (4).

4. Résistance (1) selon la revendication 3, **caractérisée en ce que** l'élément de compensation (12) comprend également une partie de la première partie de raccordement (2) qui est isolée de manière électrique par rapport au reste de la première partie de raccordement (2).

5. Résistance (1) selon la revendication 3 ou 4,
**caractérisée en ce**
a) **que** l'élément de compensation (12) est séparé de manière électrique du reste de la première partie de raccordement (2) et de l'élément de résistance (4) par un joint de séparation (17), et
b) **que** le joint de séparation (17) est pratiqué par un rayon laser ou un jet d'eau ou par fraisage dans la résistance (1), et
c) **que** le joint de séparation (17) est rempli au moins en partie d'un matériau de remplissage, et
d) **que** le matériau de remplissage est isolé de manière thermiquement conductrice et de manière électrique.

6. Résistance (1) selon l'une quelconque des revendications précédentes,
**caractérisée en ce**
a) **que** l'élément de compensation (12) présente par rapport au reste de la résistance (1) une épaisseur réduite, et
b) **que** l'épaisseur de l'élément de compensation (12) est inférieure à 50 % de l'épaisseur du reste de la résistance (1), et
c) **que** la réduction d'épaisseur de l'élément de compensation (12) est générée par enlèvement de matériau par fraisage de la résistance (1) dans la zone de l'élément de compensation (12).

7. Résistance (1) selon l'une quelconque des revendications précédentes, **caractérisée par** un diviseur de tension (R1, R2) avec deux résistances (R1, R2), dans laquelle le diviseur de tension (R1, R2) est branché en parallèle par rapport à l'élément de compensation (12) et forme avec sa prise centrale (18) une prise de tension externe.

8. Résistance (1) selon l'une quelconque des revendications précédentes,
**caractérisée en ce**
a) **qu'**est installée sur la résistance (1) une carte de circuits imprimés (19) qui supporte l'élément de compensation (12), et
b) **que** l'élément de compensation (12) est un film qui est fabriqué par une technique de gravure, et
c) **que** la carte de circuits imprimés (19) est multicouche, et
d) **que** la carte de circuits imprimés (19) est assemblée par brasage à la résistance (1).

9. Résistance (1) selon la revendication 8,
**caractérisée en ce**
a) **que** l'élément de compensation (12) est disposé sur le côté supérieur opposé à la résistance (1) ou sur une couche intérieure de la carte de circuits imprimés (19),
b) **que** la carte de circuits imprimés (19) présente un premier trou d'interconnexion électrique (23) qui établit une liaison électriquement conductrice avec la première partie de raccordement (2) et est relié de manière électriquement conductrice à la première prise de tension (7),
c) **que** la carte de circuits imprimés (19) présente un deuxième trou d'interconnexion électrique (20) qui relie l'élément de compensation (12) de manière électrique et de manière thermiquement conductrice à la deuxième partie de raccordement (3),
d) **que** la carte de circuits imprimés (19) présente une piste conductrice (21), en particulier en cuivre, qui établit une liaison électrique entre la deuxième prise de tension (8) et l'élément de compensation (12) par l'intermédiaire d'un élément de mise en contact (28) adapté,
e) **que** la carte de circuits imprimés (19) présente deux points de brasage (24, 25) que la carte de circuits imprimés (19) relie de manière thermique et de manière électrique à la première partie de raccordement (2) ou à la deuxième partie de raccordement (3),
f) **que** la carte de circuits imprimés (19) présente au moins une surface de couche intérieure (26, 27), en particulier en cuivre, qui relie l'élément de compensation (12) de manière thermique aux parties de raccordement (2, 3), et
g) **que** le diviseur de tension (R1, R2) est disposé sur la carte de circuits imprimés (19).

10. Résistance (1) selon l'une quelconque des revendications précédentes,
**caractérisée en ce**
a) **que** l'élément de compensation (12) est constitué d'un matériau qui présente sensiblement la puissance thermoélectrique identique à celle du matériau de résistance, en particulier avec un écart inférieur à ± 10 %, et
b) **que** l'élément de compensation (12) est constitué également du matériau de résistance de l'élément de résistance (4), et
c) **que** les parties de raccordement (2, 3) sont respectivement en forme de plaque, et
d) **que** l'élément de résistance (4) est en forme de plaque, et
e) **que** le matériau conducteur des parties de raccordement (2, 3) est du cuivre ou un alliage de cuivre ou de l'aluminium, et
f) **que** le matériau de résistance est un alliage de cuivre-manganèse, en particulier un alliage de cuivre-manganèse-nickel, ou un alliage de nickel-chrome, et
g) **que** le matériau de résistance de l'élément de résistance (4) présente une résistance électrique (1) spécifique plus grande que le matériau conducteur des parties de raccordement, et
h) **que** le matériau de résistance de l'élément de résistance (4) présente une résistance électrique (1) spécifique qui est inférieure à 50 • 10⁻⁷ Ωm et est supérieure à 1 • 10⁻⁸ Ωm, et
i) **que** la résistance (1) présente une valeur de résistance qui est d'au moins 0,1 µΩ et au maximum de 1000 µΩ.

11. Procédé de fabrication pour une résistance (1), en particulier pour une résistance de mesure de courant (1) à basse impédance selon l'une quelconque des revendications précédentes, avec les étapes suivantes :
a) la fourniture de la résistance (1) avec une première partie de raccordement (2) composée d'un matériau conducteur, une deuxième partie de raccordement (3) composée du matériau conducteur et un élément de résistance (4) composé d'un matériau de résistance,
a1) dans lequel l'élément de résistance (4) est disposé dans le sens du courant entre la première partie de raccordement (2) et la deuxième partie de raccordement (3) et est traversé par le courant électrique (I),
a2) dans lequel le matériau de résistance présente une certaine puissance thermoélectrique qui génère, dans le cas d'une différence de température entre l'élément de résistance (4) d'une part et les parties de raccordement (2, 3) d'autre part, une certaine tension thermoélectrique,
a3) dans lequel une première prise de tension (7) est reliée de manière électriquement conductrice à la première partie de raccordement (2),
a4) dans lequel une deuxième prise de tension (8) est reliée de manière électriquement conductrice à la deuxième partie de raccordement (3),
a5) dans lequel un circuit de mesure de tension (9, 10, 11) est raccordé à la première prise de tension (7) et à la deuxième prise de tension (8) pour mesurer la tension sur l'élément de résistance (4),
b) la fourniture d'un élément de compensation (12) sur la résistance (1), dans lequel l'élément de compensation (12) génère lors du fonctionnement une tension thermoélectrique qui compense au moins en partie la tension thermoélectrique générée par l'élément de résistance (4),
**caractérisé en ce**
c) que la deuxième prise de tension (8) est disposée sur la première partie de raccordement (2),
d) que la deuxième prise de tension (8) est isolée de manière électrique par rapport à la première partie de raccordement (2),
e) que l'élément de compensation (12) est relié de manière thermiquement conductrice à la première partie de raccordement (2) sur la deuxième prise de tension (8),
f) que la deuxième prise de tension (8) est reliée de manière électriquement conductrice à un point de contact (13) sur la deuxième partie de raccordement (3) par l'intermédiaire de l'élément de compensation (12), et
g) que l'élément de compensation (12) est relié de manière électrique et de manière thermiquement conductrice à la deuxième partie de raccordement (3) sur le point de contact (13) sur la deuxième partie de raccordement (3).

12. Procédé de fabrication selon la revendication 11,
**caractérisé par** des étapes suivantes :
a) la pratique d'un joint de séparation (17) dans la résistance (1) pour séparer l'élément de compensation (12) par rapport au reste de l'élément de résistance (4), en particulier au moyen
a1) d'un rayon laser,
a2) d'un jet d'eau, ou
a3) d'une fraise, et/ou
b) le remplissage du joint de séparation (17) avec un matériau de remplissage qui est électriquement isolant et thermiquement conducteur, et/ou
c) la réduction de l'épaisseur de l'élément de compensation (12) par rapport au reste de la résistance (1), en particulier par enlèvement de matériau par fraisage de l'élément de compensation (12).
